(19) **Europäisches Patentamt**
**European Patent Office**
**Office européen des brevets**

(11) **EP 4 734 388 A1**

(12) **EUROPEAN PATENT APPLICATION**
published in accordance with Art. 153(4) EPC

(43) Date of publication:
**29.04.2026 Bulletin 2026/18**

(21) Application number: **23948467.8**

(22) Date of filing: **09.08.2023**

(51) International Patent Classification (IPC):
**H04B 7/06** (2006.01)   **H04B 7/08** (2006.01)

(52) Cooperative Patent Classification (CPC):
**H04B 7/06; H04B 7/08**

(86) International application number:
**PCT/JP2023/029013**

(87) International publication number:
**WO 2025/032747 (13.02.2025 Gazette 2025/07)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **MITSUBISHI ELECTRIC
CORPORATION
Chiyoda-ku
Tokyo 100-8310 (JP)**

(72) Inventor: **TAKAHASHI, Toru
Tokyo 100-8310 (JP)**

(74) Representative: **Pfenning, Meinig & Partner mbB
Patent- und Rechtsanwälte
An der Frauenkirche 20
01067 Dresden (DE)**

(54) **ANTENNA MEASUREMENT DEVICE**

(57)   An antenna measurement device (2) that estimates an element electric field of a plurality of element antennas ($11_1$) to ($11_M$) in a transmission device (1) including an array antenna (10) including the element antennas ($11_1$) to ($11_M$) in which an excitation weight indicating an amplitude and a phase with respect to each of the plurality of element antennas ($11_1$) to ($11_M$) is changed, the antenna measurement device (2) including: a probe antenna (21) to receive a high-frequency signal radiated by the array antenna (10); a receiver (22) to detect a reception signal received by the probe antenna (21) and output an array response that is the detected reception signal in chronological order; and an element electric field estimating unit (23) to estimate an element electric field of each of the plurality of element antennas ($11_1$) to ($11_M$) using a Kalman filter that receives inputs of an array response output from the receiver (22) in chronological order and an excitation weight vector obtained by the excitation weight for each of the plurality of element antennas ($11_1$) to ($11_M$).

FIG. 1

**Description**

TECHNICAL FIELD

The present disclosure relates to an antenna measurement device used in a transmission system or a reception system.

BACKGROUND ART

Non Patent Literature 1 discloses a technique of measuring, in a phased array antenna, a signal (hereinafter, referred to as an element electric field) received by each element antenna (hereinafter, an element antenna is simply referred to as an element) constituting the phased array antenna.

Further, Non Patent Literature 2 discloses a technique of measuring signals (hereinafter, referred to as an element electric field) transmitted from elements constituting a phased array antenna.

Non Patent Literature 1 discloses a technique of estimating an element electric field of each element by simultaneously changing a phase of each phase shifter connected to each of at least two elements constituting a phased array antenna, measuring a change in an array combining signal (hereinafter, referred to as an array response) at that time, and performing Fourier transform on the change in the array response.

In addition, Non Patent Literature 2 discloses a technique in which a probe antenna is arranged in a phased array antenna, an array response when beam scanning is performed in a plurality of directions is measured, and each element electric field is estimated from a change in the array response and a steering matrix corresponding to the beam scanning using a least squares method or a pseudo inverse matrix.

CITATION LIST

NON PATENT LITERATURES

Non Patent Literature 1: G.A. Hampson and A.B. Smolder, "A Fast Accurate Scheme for Calibration of Active Phased-Array Antennas", 1999 IEEE AP-S Int. Symp. Digest, pp.1040-1043, 1999.
Non Patent Literature 2: Z. Wang, F. Zhang, H. Gao, O. Franek, G. F. Pedersen, and W. Fan, "Over-the-Air Array Calibration of mmWave Phased Array in Beam-Steering Mode Based on Measured Complex Signals", IEEE Trans AP, vol.69, no. 11, pp. 7876-7888, 2021.

SUMMARY OF INVENTION

TECHNICAL PROBLEM

In the technique of measuring an element electric field disclosed in Non Patent Literature 1, in order to estimate each element electric field, an excitation phase of each element is changed on the basis of a specific sequence, and an array response at that time is measured. For this reason, during a period in which a phased array antenna is incorporated and operated in a wireless system such as wireless communication or radar, a change in the excitation phase of each element does not necessarily depend on a specific sequence, and thus there is a problem that each element electric field cannot be estimated.

Furthermore, in the technique of measuring the element electric field disclosed in Non Patent Literature 1, it is assumed that each element electric field is unchanged except for a change in the excitation phase while the excitation phase of each element is changed on the basis of a specific sequence, and thus there is also a problem that it is not possible to obtain a highly accurate estimation value of each element electric field in a case where the element electric field changes from moment to moment due to, for example, a temperature change, a secular change, or the like.

In addition, in the technique of measuring an element electric field disclosed in Non Patent Literature 2, in order to estimate each element electric field, beam scanning is performed in a plurality of directions, and an array response at that time is measured.

In the technique of measuring an element electric field disclosed in Non Patent Literature 2, since beam scanning is generally performed even during a period in which the phased array antenna is incorporated and operated in a wireless system such as wireless communication or radar, each element electric field can be estimated.

However, in the technique of measuring the element electric field disclosed in Non Patent Literature 2, it is assumed that each element electric field is unchanged except for the change in the excitation phase accompanying the beam scanning while the beam scanning is performed in a plurality of directions, and thus there is a problem that it is not possible to obtain a highly accurate estimation value of each element electric field in a case where the element electric field changes from moment to moment due to, for example, a temperature change, a secular change, or the like.

The present disclosure solves the above-described problems, and an object of the present disclosure is to obtain an antenna measurement device capable of estimating an element electric field even during a period in which an array antenna is incorporated in a wireless system such as wireless communication or radar and is operated as a transmission system, and capable of obtaining a highly accurate estimation value of the element electric field even if the element electric field changes due to a temperature change, a secular change, or the like.

SOLUTION TO PROBLEM

An antenna measurement device according to the present disclosure is an antenna measurement device that estimates an element electric field of a plurality of element antennas in a transmission device including an array antenna including the element antennas in which an excitation weight indicating an amplitude and a phase with respect to each of the plurality of element antennas is changed, the antenna measurement device including: a probe antenna to receive a high-frequency signal radiated by the array antenna; a receiver to detect a reception signal received by the probe antenna and output an array response that is the detected reception signal in chronological order; and an element electric field estimating unit to estimate an element electric field of each of the plurality of element antennas using a Kalman filter that receives inputs of the array response output from the receiver in chronological order and an excitation weight vector obtained by the excitation weight for each of the plurality of element antennas.

ADVANTAGEOUS EFFECTS OF INVENTION

According to the present disclosure, it is possible to estimate an element electric field even during a period in which it is operated as a transmission system, and it is possible to obtain a highly accurate estimation value of the element electric field even if the element electric field changes due to a temperature change, a secular change, or the like.

BRIEF DESCRIPTION OF DRAWINGS

FIG. 1 is a configuration diagram illustrating a transmission system including an antenna measurement device according to a first embodiment.
FIG. 2 is a flowchart illustrating an example of a procedure for sequentially estimating an element electric field in an element antenna using a Kalman filter in the antenna measurement device according to the first embodiment.
FIG. 3 is a configuration diagram illustrating a transmission system including an antenna measurement device according to a fourth embodiment.
FIG. 4 is a configuration diagram illustrating a transmission system including an antenna measurement device according to a fifth embodiment.
FIG. 5 is a configuration diagram illustrating a transmission system including an antenna measurement device according to an eighth embodiment.
FIG. 6 is a configuration diagram illustrating a transmission system including an antenna measurement device according to a ninth embodiment.
FIG. 7 is a configuration diagram illustrating a transmission system including an antenna measurement device according to a tenth embodiment.
FIG. 8 is a configuration diagram illustrating a transmission system including an antenna measurement device according to an eleventh embodiment.
FIG. 9 is a configuration diagram illustrating a reception system including an antenna measurement device according to a twelfth embodiment.

DESCRIPTION OF EMBODIMENTS

First Embodiment

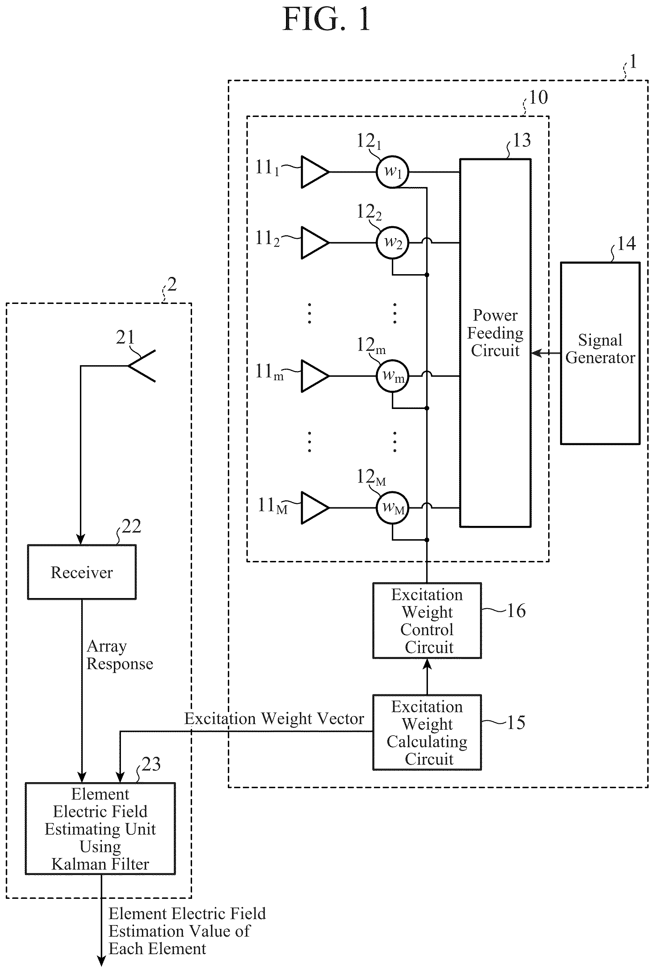

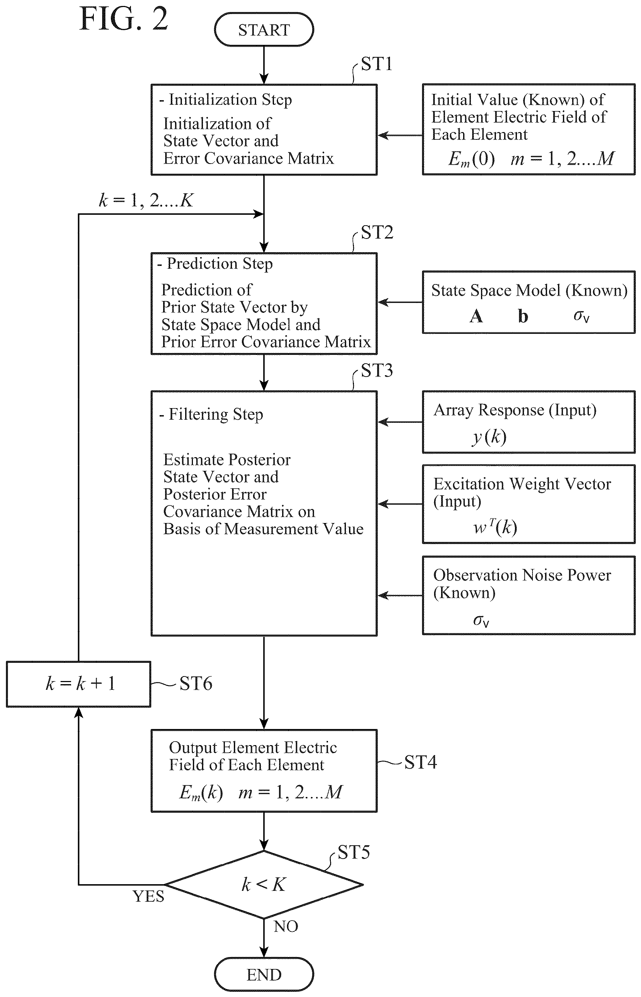

An antenna measurement device according to a first embodiment will be described with reference to FIGS. 1 and 2.
FIG. 1 is a configuration diagram illustrating a schematic configuration of a transmission system including an antenna measurement device according to the first embodiment.

As illustrated in FIG. 1, the transmission system includes a transmission device 1 and an antenna measurement device 2.

Note that the transmission system is an assembly of components used when radiating a high-frequency signal in a wireless system.

The transmission device 1 includes an array antenna 10, a signal generator 14, an excitation weight calculating circuit 15, and an excitation weight control circuit 16.

The array antenna 10 includes a plurality of element antennas (hereinafter, referred to as an element) $11_1$ to $11_M$, a plurality of excitation weight adjusting circuits $12_1$ to $12_M$, and a power feeding circuit 13.

The array antenna 10 includes a plurality of elements $11_1$ to $11_M$, and is an array antenna in which excitation weights indicating an amplitude and a phase with respect to each of the plurality of elements $11_1$ to $11_M$ is changed.

The plurality of elements $11_1$ to $11_M$ is transmission/reception reversible element antennas that can be used for transmission and reception.

The antenna measurement device 2 estimates, that is, measures an element electric field of each of the plurality of elements $11_1$ to $11_M$.

The element electric field referred to herein means a high-frequency signal radiated from each of the plurality of elements $11_1$ to $11_M$, and is a complex number representing the amplitude and phase of the radiated high-frequency signal.

The antenna measurement device 2 includes a probe antenna 21, a receiver 22, and an element electric field estimating unit 23 using a Kalman filter.

The receiver 22 is not limited to a dedicated receiver for estimating the element electric field of each of the plurality of elements $11_1$ to $11_M$, and may use a receiver of a reception system used when a high-frequency signal is received in a wireless system.

Note that, in the following description, when it is not necessary to individually describe each of the elements $11_1$ to $11_M$ and the excitation weight adjusting circuits $12_1$ to $12_M$, and common matters will be described without suffixes in order to avoid complication of description.

The array antenna 10 is a generally known array antenna such as a linear array antenna in which a plurality of elements 11 is arranged linearly, a planar array antenna in which a plurality of elements 11 is arranged in a matrix in a planar manner, or a circular array antenna in which a plurality of elements 11 is arranged in a matrix in a planar manner.

The number of elements 11 will be described as M. M is a natural number of 2 or more.

Each element 11 radiates a high-frequency signal to which a change in amplitude and phase is given by the corresponding excitation weight adjusting circuit 12 into space.

Each of the plurality of excitation weight adjusting circuits 12 is an adjustment unit that adjusts an excitation weight given to each of the plurality of corresponding elements 11.

Each excitation weight adjusting circuit 12 is controlled on the basis of the excitation weight from the excitation weight control circuit 16.

Each excitation weight adjusting circuit 12 may be configured as either an analog circuit or a digital circuit, and a generally known excitation weight adjusting circuit is used.

The power feeding circuit 13 is a power distributing circuit that is a power feeding unit for distributing the high-frequency signal from the signal generator 14 and supplying the high-frequency signal from the signal generator 14 to each of the plurality of elements 11.

The power feeding circuit 13 may be configured in any form of an analog circuit or a digital circuit, and a generally known power distributing circuit is used.

The excitation weight calculating circuit 15 calculates an excitation weight to be given to each of the plurality of elements 11.

The excitation weight control circuit 16 controls the plurality of excitation weight adjusting circuits 12 on the basis of the excitation weights calculated by the excitation weight calculating circuit 15.

The excitation weight control circuit 16 controls each excitation weight adjusting circuit 12 to change the excitation weight for each element 11.

In short, each excitation weight adjusting circuit 12 changes the amplitude and phase of the high-frequency signal from the power feeding circuit 13 on the basis of the excitation weight from the excitation weight control circuit 16, and supplies the high-frequency signal from the power feeding circuit 13 to each element 11.

That is, the high-frequency signal transmitted from the signal generator 14 is power-distributed by the power feeding circuit 13. The amplitude and the phase of the power-distributed high-frequency signal are changed by each excitation weight adjusting circuit 12 controlled by the excitation weight from the excitation weight control circuit 16. A high-frequency signal having a change in amplitude and phase is radiated into space from each element 11 constituting the array antenna 10.

The probe antenna 21 is installed to be opposite to the array antenna 10. That is, the probe antenna 21 is a reception antenna that is installed at a position opposite to the plurality of elements 11 and receives the high-frequency signal radiated from the array antenna 10.

The high-frequency signal received by the probe antenna 21 is a combined signal obtained by combining the high-frequency signals radiated from the plurality of elements 11 in space.

The receiver 22 sequentially detects the reception signal received by the probe antenna 21, that is, the array response which is an array combining signal.

The element electric field estimating unit 23 sequentially estimates the element electric field of each of the plurality of elements 11 using a Kalman filter that receives inputs of the array response sequentially output from the receiver 22 and an excitation weight vector obtained by the excitation weight for each of the plurality of elements 11 calculated by the excitation weight calculating circuit 15, and obtains an element electric field estimation value of each element 11.

Next, a method for obtaining the element electric field estimation value using the Kalman filter in the element electric field estimating unit 23 of the antenna measurement device 2 according to the first embodiment will be described.

First, before describing the method of obtaining the element electric field estimation value using a Kalman filter, a state equation representing a state space model of an element electric field of each element 11 and an observation equation at the time of array response measurement will be described.

Now, a description will be given assuming that a series of procedures for sequential estimation is repeated K times in chronological order from an index 1 to an index K.

The index represents the number of times of a series of procedures of changing the excitation weight of each element 11, measuring the array response, and sequentially estimating the element electric field estimation value of each element 11.

That is, in a series of procedures for sequential estimation when the transmission system is incorporated into a wireless system such as wireless communication or radar and is in operation, the excitation weight calculating circuit 15 calculates the excitation weight of each element 11, changes the excitation weight for each element 11 on the basis of the calculation result, sets the number of times of obtaining the element electric field estimation value by the array response detected by the receiver 22 from the high-frequency signal received by the probe antenna 21 as K times, and indicates each time as an index.

Further, in the following description, k (= 1 to K) represents an index 1 to an index K, represents the number of times of a series of procedures for sequentially estimating the element electric field of each element 11, and corresponds to the k-th number of steps. Hereinafter, the procedure with the index k (= 1 to K) will be described.

$w^T(k)$ is an excitation weight vector (complex vector) obtained by the excitation weight for each of the plurality of elements 11 calculated by the excitation weight calculating circuit 15, $y(k)$ is an array response (complex number), and $E_m(k)$ is an element electric field (complex number) of the element $11_m$ to be estimated.

When the excitation weight of the element $11_m$ is represented by $w_m(k)$ (complex number), the excitation weight vector $w^T(k)$ can be expressed by the following Expression (1). m is 1 to M.

$$w^T(k) \;=\; [w_1(k)\,w_2(k)\,...\,w_M(k)]\,...\,(1)$$

In addition, a sequential variation amount (complex number) of the element electric field of the element $11_m$ is defined as $\Delta E_m(k)$, and a state vector $x^T(k)$ having the number of elements of 2M is defined by the following Expression (2).

$$x^T(k) \;=\; [E_1(k)\,E_2(k)\,...\,E_M(k)\,\Delta E_1(k)\,\Delta E_2(k)$$
$$...\,\Delta E_M(k)]\,...\,(2)$$

At this time, an error covariance matrix $P(k)$ of (2M×2M) elements is also defined. The initial value of the error covariance matrix $P(k)$ is, for example, an identity matrix.

Furthermore, a state equation representing a state space model of the element electric field of each element $11_m$ can be expressed by the following Expression (3).

$$x(k+1) \;=\; Ax(k) \;+\; v_k b\,...\,(3)$$

In the above Expression (3), A is a matrix of (2M×2M) elements and is expressed by the following Expression (4), b is a vector of 2M elements and is expressed by the following Expression (5), $v_k$ is a system driving noise and a random variable according to a Gaussian distribution with an average of 0, and its standard deviation is $\sigma_v$.

$$\mathbf{A}=\begin{bmatrix} \mathbf{I}_M & \mathbf{I}_M \\ \mathbf{0}_{M,M} & \mathbf{I}_M \end{bmatrix} \qquad\qquad \cdot\cdot\cdot\;(4)$$

$$\mathbf{b} = \begin{bmatrix} \mathbf{0}_{M,1} \\ \mathbf{1}_{M,1} \end{bmatrix} \qquad \qquad \cdots (5)$$

In the above Expression (4), $I_M$ is an identity matrix of $(M \times M)$, $0_{M,M}$ is a zero matrix of $(M \times M)$, and in the above Expression (5), $0_{M,1}$ is a zero vector of the number of elements M, and $1_{M,1}$ is a vector of the number of elements M in which all elements are 1.

According to the state space model given by the above Expressions (3), (4), and (5), the (k+1)th element electric field $E_m(k+1)$ can be expressed by the following Expression (6).

$$E_m(k+1) = E_m(k) + \Delta E_m(k) \ldots (6)$$

In the above Expression (6), $\Delta E_m(k)$ is a sequential variation amount of the element electric field, and can be expressed by the following Expression (7).

$$\Delta E_m(k+1) = \Delta E_m(k) + v_k \ldots (7)$$

As understood from the above Expression (7), a sequential variation amount $\Delta E_m(k)$ of the element electric field is a model that randomly varies.

Note that the state space model given by the above Expressions (4) to (7) is an example, and another state space model representing a change in the element electric field may be used.

Further, when observation noise at the time of array response measurement is $u_k$, the observation equation is obtained by the following Expression (8), and the array response y(k) detected by the receiver 22 can be expressed by the following Expression (8).

$$y(k) = C^T(k) \ x \ (k) + u_k \ldots (8)$$

In the above Expression (8), $C^T(k)$ is a vector including the excitation weight vector $w^T(k)$ illustrated in the above Expression (1) and a zero vector, and can be expressed by the following Expression (9).

$$C^T(k) = [w^T(k) \ 0_{1,M}] \ldots (9)$$

Since the state equation and the observation equation are defined as described above, a procedure for sequentially estimating the element electric field of each of the plurality of elements 11 using the Kalman filter constituting the element electric field estimating unit 23 and obtaining the element electric field estimation value of each element 11 will be described with reference to FIG. 2.

In step ST1, the state vector $x^T(k)$ and the error covariance matrix P(k) are initialized.

Assuming that an initial value of the element electric field of the element $11_m$ (m is 1 to M) measured in advance is $E_m(0)$, an initial value $x^T(0)$ of the state vector $x^T(k)$ can be expressed by the following Expression (10). 0 in () indicates an initial value, and k = 0.

$$x^T(0) = [E_1(0) E_2(0) \ldots E_M(0) 0 0 \ldots 0] \ldots (10)$$

The above Expression (10) is obtained by substituting the initial value $E_m(0)$ of the element electric field and the sequential variation amount $\Delta E_m(0) = 0$ of the element electric field in the above Expression (2).

The initial value P(0) of the error covariance matrix P(k) is, for example, an identity matrix.

Step ST1 is an initialization step.

In step ST2, a prior state vector x bar (k) by the state space model at the index 1 is obtained by the following Expression (11), and a prior error covariance matrix P bar (k) is obtained by the following Expression (12).

$$\overline{\mathbf{x}}(k) = \mathbf{A}\mathbf{x}(k) \qquad \qquad \cdots (11)$$

$$\overline{\mathbf{P}}(k) = \mathbf{A}\mathbf{P}(k-1)\mathbf{A}^H + \sigma_v^2 \mathbf{b}\mathbf{b}^T \qquad \qquad \cdots (12)$$

In the above Expressions (11) and (12), a matrix A of $(2M \times 2M)$ elements is a known matrix represented by the above Expression (4), and in the above Expression (12), $A^H$ is Hermitian transposition of the matrix A, a vector b of 2M elements is a known vector represented by the above Expression (5), $b^T$ is transposition of the vector b, and a standard deviation $\sigma_v$ is a known value.

Step ST2 is a prediction step of obtaining the prior state vector x bar (k) and the prior error covariance matrix P bar (k) by the state space model.

In step ST3, a posterior state vector x(k) is obtained by the following Expression (13) and a posterior error covariance matrix P(k) is obtained by the following Expression (14) on the basis of the array response y(k) which is a measurement value detected by the receiver 22 from the reception signal received by the probe antenna 21 at the index 1.

$$\mathbf{x}(k) = \overline{\mathbf{x}}(k) + \mathbf{g}(k)\left[ y(k) - \mathbf{c}^T(k)\overline{\mathbf{x}}(k) \right] \qquad \cdots \quad (13)$$

$$\mathbf{P}(k) = \left[ \mathbf{I} - \mathbf{g}(k)\mathbf{c}^T(k) \right]\overline{\mathbf{P}}(k) \qquad \cdots \quad (14)$$

In the above Expressions (13) and (14), g(k) is a Kalman gain and can be expressed by the following Expression (15).

$$\mathbf{g}(k) = \frac{\overline{\mathbf{P}}(k)\mathbf{c}^*(k)}{\mathbf{c}^T(k)\overline{\mathbf{P}}(k)\mathbf{c}^*(k) + \sigma^2} \qquad \cdots \quad (15)$$

That is, in step ST3, the Kalman filter constituting the element electric field estimating unit 23 receives the array response y(k), which is the measurement value detected by the receiver 22, the excitation weight vector $w^T(k)$ obtained by the excitation weight for each of the plurality of elements 11 calculated by the excitation weight calculating circuit 15, and the standard deviation $\sigma_v$, and a state vector x(k) is obtained by the above Expression (13).

Step ST3 is a filtering step of obtaining the state vector x(k) and the error covariance matrix P(k) on the basis of the array response y(k) detected by the receiver 22 and the excitation weight vector $w^T(k)$ which are measurement values using the Kalman filter.

The state vector x(k) obtained by the above Expression (13) can be expressed by a complex vector having the element electric field $E_m(k)$ of the element $11_m$ and the variation amount $\Delta E_m(k)$ of a sequential element electric field of the element electric field of the element $11_m$ as elements as indicated by the state vector $x^T(k)$ by the above Expression (2).

Therefore, by obtaining the state vector x(k) by the procedure of steps ST1 to ST3, the element electric field $E_m(k)$ (m = 1 to M) of the element $11_m$ can be estimated from the above Expression (2).

Step ST4 is an element electric field estimation step in which the element electric field estimating unit 23 using the Kalman filter obtains the element electric field $E_m(k)$ of each element $11_m$ as the element electric field estimation value of each element $11_m$ by the state vector x(k).

In step ST5, it is determined whether or not k is less than K, and in a case where k is less than K, the process proceeds to step ST6, k is changed to k+1 in step ST6, the process returns to step ST2, and a series of procedures from step ST2 to step ST6 is repeated until k becomes K.

In step ST5, when k is K, the series of procedures is ended.

As a result, the element electric field estimating unit 23 sequentially calculates and outputs the element electric field $E_m(k)$ of each element $11_m$ K times with the index k from 1 to K, so that the element electric field $E_m(k)$ of each element $11_m$ that changes from moment to moment can be sequentially estimated.

Therefore, even if the element electric field of the element 11 changes due to a temperature change, a secular change, or the like of the environment of the transmission device 1, a highly accurate estimated value of the element electric field can be obtained.

As described above, the antenna measurement device according to the first embodiment is the antenna measurement device 2 that estimates an element electric field of the plurality of element antennas $11_1$ to $11_M$ in the transmission device 1 including the array antenna 10 including the element antennas $11_1$ to $11_M$ in which an excitation weight indicating an amplitude and a phase with respect to each of the plurality of element antennas $11_1$ to $11_M$ is changed, and includes: the probe antenna 21 to receive a high-frequency signal radiated by the array antenna 10; the receiver 22 to detect a reception signal received by the probe antenna 21 and output an array response that is the detected reception signal in chronological order; and the element electric field estimating unit 23 to estimate the element electric field of each of the plurality of element antennas $11_1$ to $11_M$ using the Kalman filter that receives inputs of an array response output from the receiver 22 in chronological order and an excitation weight vector obtained by the excitation weight for each of the plurality of element antennas $11_1$ to $11_M$, and thus the element electric field of each of the plurality of element antennas $11_1$ to $11_M$ can be sequentially estimated.

As a result, even if the element electric field of the element antenna $11_1$ to $11_M$ changes due to a temperature change, a secular change, or the like of the environment of the transmission device 1, a highly accurate estimation value of the element electric field can be obtained.

Furthermore, the element electric field of the element antenna $11_1$ to $11_M$ can be estimated even during the period in which the transmission device 1 is operated.

Second Embodiment

An antenna measurement device according to a second embodiment is characterized in that a high-frequency signal radiated from each element 11 is made to be an orthogonal beam by an excitation weight based on an excitation weight adjusting circuit 12, whereas the high-frequency signal radiated from each of the plurality of elements 11 can be any beam in the antenna measurement device according to the first embodiment, and the other points are the same.

A transmission system including the antenna measurement device according to the second embodiment is substantially the same as that of FIG. 1 illustrated in the first embodiment, and is characterized in the following points with respect to the antenna measurement device according to the first embodiment.

That is, in order to radiate an orthogonal beam group from the array antenna 10 including the plurality of elements 11, the excitation weight of each element 11 provided by each of the plurality of excitation weight adjusting circuits 12 is sequentially switched by the excitation weight control circuit 16 to be an excitation weight for forming an orthogonal beam.

On the other hand, on the basis of a reception signal received by the probe antenna 21, the receiver 22 measures an array response corresponding to each orthogonal beam.

The antenna measurement device according to the second embodiment has effects similar to those of the antenna measurement device according to the first embodiment, and moreover, since the excitation weight is used as an excitation weight for the plurality of elements 11 to form orthogonal beams, there is no correlation between measurement results of the array response, and thus estimation accuracy of the element electric field of each element 11 is improved.

Third Embodiment

An antenna measurement device according to a third embodiment is characterized in that an initial value $E_m(0)$ of an element electric field of an element $11_m$ is obtained by a method similar to the method for estimating the element electric field $E_m(k)$ of each element 11, whereas the initial value $E_m(0)$ of the element electric field of the element $11_m$ can be acquired in advance by any acquisition method in the antenna measurement device according to the first embodiment, and the other points are the same.

A transmission system including the antenna measurement device according to the third embodiment is substantially the same as that of FIG. 1 illustrated in the first embodiment, and is characterized in the following points with respect to the antenna measurement device according to the first embodiment.

In the antenna measurement device according to the third embodiment, the initial value $E_m(0)$ of the element electric field of the element $11_m$ used in step ST1, which is an initialization step for the Kalman filter constituting the element electric field estimating unit 23 described in the first embodiment, is obtained as follows.

That is, before the element electric field $E_m(k)$ of each element 11 is estimated, that is, in advance, similarly to the estimation of the element electric field $E_m(k)$ of each element 11, a procedure similar to steps ST2 to ST5 illustrated in FIG. 2 is repeated K times from the index 1 to the index K in chronological order to obtain the initial value $E_m$ of the element electric field of the element $11_m$.

It is assumed that the element electric field of the element $11_m$ does not change in a period of k from 1 to K performed in advance.

With respect to initial values $E_1$ to $E_M$ of the element electric fields of the elements $11_1$ to $11_M$, which are unknown, the relationship between array responses $y(1)$ to $y(K)$, which are measurement values, and excitation weight vectors $w^T(1)$ to $w^T(K)$ can be expressed by a linear equation illustrated in the following Expression (16).

$$\begin{bmatrix} y(1) \\ y(2) \\ \vdots \\ y(K) \end{bmatrix} = \begin{bmatrix} \mathbf{w}^T(1) \\ \mathbf{w}^T(2) \\ \vdots \\ \mathbf{w}^T(K) \end{bmatrix} \begin{bmatrix} E_1 \\ E_2 \\ \vdots \\ E_M \end{bmatrix} \qquad \cdots \quad (16)$$

Since the array response $y(k)$ is a measurement value and the excitation weight vector $w^T(k)$ can be expressed by the above Expression (1) using an excitation weight $w_m(k)$ of the element $11_m$, the initial values $E_1$ to $E_M$ of the element electric field of the elements $11_1$ to $11_M$ can be obtained by solving the linear equation of the above Expression (16).

In short, the initial values $E_1$ to $E_M$ of the element electric fields of the elements $11_1$ to $11_M$ are values of the element electric fields obtained by an array response output from a receiver 22 and the excitation weight vectors $w^T(1)$ to $w^T(K)$ obtained by the excitation weights $w_1(1)$ to $w_M(k)$ for the elements $11_1$ to $11_M$ in a period in which the element electric fields of the plurality of elements $11_1$ to $11_M$ do not change.

Note that, as a solution to the linear equation of the above Expression (16), a conventional solution such as multiplying both sides of the above Expression (16) by an inverse matrix or a pseudo inverse matrix, solving by a least squares method, or the like can be used.

The antenna measurement device according to the third embodiment has effects similar to those of the antenna measurement device according to the first embodiment, and also has an effect that the initial value E of the element electric field of the element 11 can be obtained by a method similar to the method of estimating the element electric field of the element 11 using the antenna measurement device since the initial value is set to the value of the element electric field obtained from the array response output from the receiver 22 and the excitation weight for each of the plurality of elements 11.

Note that, in the antenna measurement device according to the third embodiment, as in the antenna measurement device according to the second embodiment, an orthogonal beam group may be selected as a high-frequency signal radiated from each element 11.

Fourth Embodiment

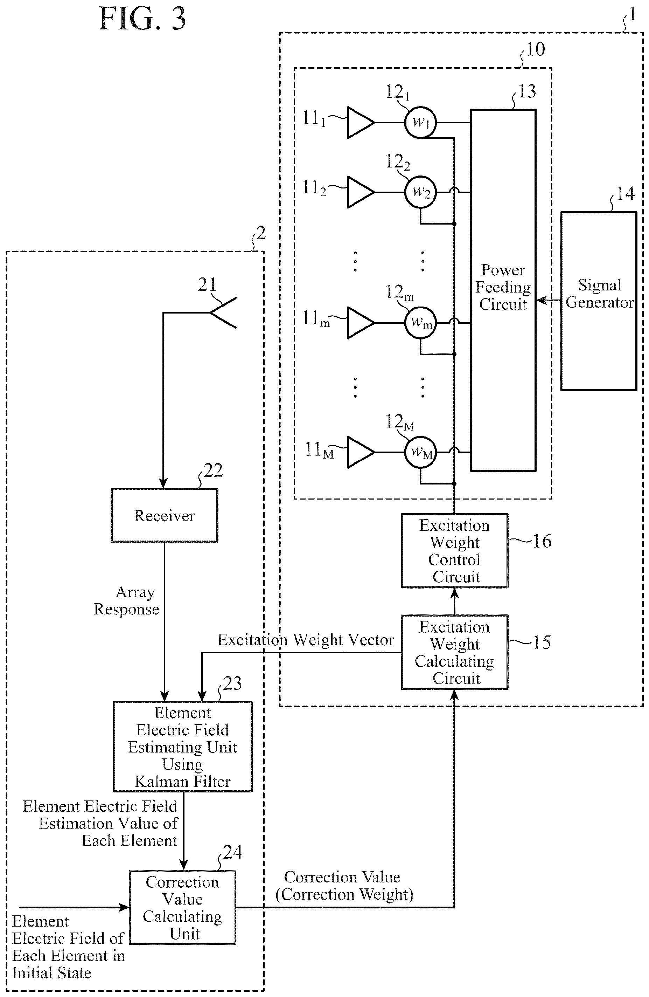

An antenna measurement device according to a fourth embodiment will be described with reference to FIG. 3.

The antenna measurement device according to the fourth embodiment is different in that an excitation weight calculated by an excitation weight calculating circuit 15 is corrected, that is, calibrated, using an element electric field estimation value of each element 11 obtained by the antenna measurement device according to the first embodiment, and the other points are the same.

Note that, in FIG. 3, the same reference numerals as those attached in FIGS. 1 to 2 denote the same or corresponding parts.

An antenna measurement device 2 according to the fourth embodiment measures and estimates an element electric field of each of a plurality of elements $11_1$ to $11_M$, calculates a variation amount of the element electric field in an initial state of each element 11 with respect to an initially set excitation weight in the excitation weight calculating circuit 15 using the estimated element electric field, and outputs a correction value based on the calculated variation amount to the excitation weight calculating circuit 15.

The excitation weight calculating circuit 15 calculates a correction excitation weight for the initially set excitation weight on the basis of the correction value, calculates an excitation weight to be given to each of the plurality of elements 11 on the basis of the calculated correction excitation weight, and outputs a calculation result to an excitation weight control circuit 16.

The antenna measurement device 2 includes a probe antenna 21, a receiver 22, an element electric field estimating unit 23, and a correction value calculating unit 24.

Since the difference from the antenna measurement device 2 according to the first embodiment is that the antenna measurement device 2 according to the fourth embodiment includes the correction value calculating unit 24, the correction value calculating unit 24 will be mainly described below.

The correction value calculating unit 24 compares an element electric field estimation value $E_m(k)$ of each element 11 estimated by the element electric field estimating unit 23 with the element electric field in the initial state of each element 11 with respect to the initially set excitation weight in the excitation weight calculating circuit 15, and calculates the variation amount of the element electric field estimation value of each element 11.

The correction value calculating unit 24 outputs the calculated variation amount to the excitation weight calculating circuit 15 as a correction value (correction weight) for returning the element electric field of each element 11 to the element electric field in the initial state.

The element electric field estimation value $E_m(k)$ of each element 11 estimated by the element electric field estimating unit 23 is the same as that obtained by the series of procedures of steps ST1 to ST6 described with reference to FIG. 2 in the first embodiment.

The excitation weight calculating circuit 15 calculates a corrected excitation weight for the initially set excitation weight on the basis of the correction value from the correction value calculating unit 24, and calculates an excitation weight to be given to each of the plurality of elements 11 on the basis of the calculated corrected excitation weight.

The excitation weight calculated by the excitation weight calculating circuit 15 is output to an excitation weight control circuit 16, and the excitation weight control circuit 16 and the excitation weight adjusting circuits 12 operate as described in the first embodiment.

As a result, a high-frequency signal from a power feeding circuit 13 is set to the amplitude and phase of an excitation current (voltage) on the basis of the calibrated excitation weight, and is radiated from each element 11 into the space.

Therefore, the element electric field of each element 11 is the same as the element electric field in the initial state.

That is, even if the element electric field of the element 11 changes due to a temperature change, a secular change, or the like of the environment of the transmission device 1, a fluctuation of the element electric field of each element 11 can be sequentially corrected, and the element electric field of each element 11 can be maintained constant.

Note that the excitation weight given to each element 11 may be an excitation weight for forming an orthogonal beam as described in the second embodiment. With this configuration, the estimation accuracy of the element electric field of each element 11 is improved.

In addition, the initial value $E_m$ of the element electric field of each element 11 may be obtained by solving the linear equation of the above Expression (16) in advance using the antenna measurement device 2 as described in the third embodiment.

Similarly to the antenna measurement device according to the first embodiment, the antenna measurement device according to the fourth embodiment can sequentially estimate the element electric field of each of the element antennas $11_1$ to $11_M$ with high accuracy, and further includes the correction value calculating unit 24 that compares the element electric field of each of the plurality of element antennas $11_1$ to $11_M$ estimated by the element electric field estimating unit 23 using the Kalman filter with the element electric field in the initial state of each of the plurality of element antennas $11_1$ to $11_M$, calculates the variation amount with respect to the element electric field in the initial state, and obtains the variation amount as the correction value of the excitation weight, and thus, even when the element electric field of each of the plurality of element antennas $11_1$ to $11_M$ varies, it is possible to sequentially maintain the element electric field constant.

Fifth Embodiment

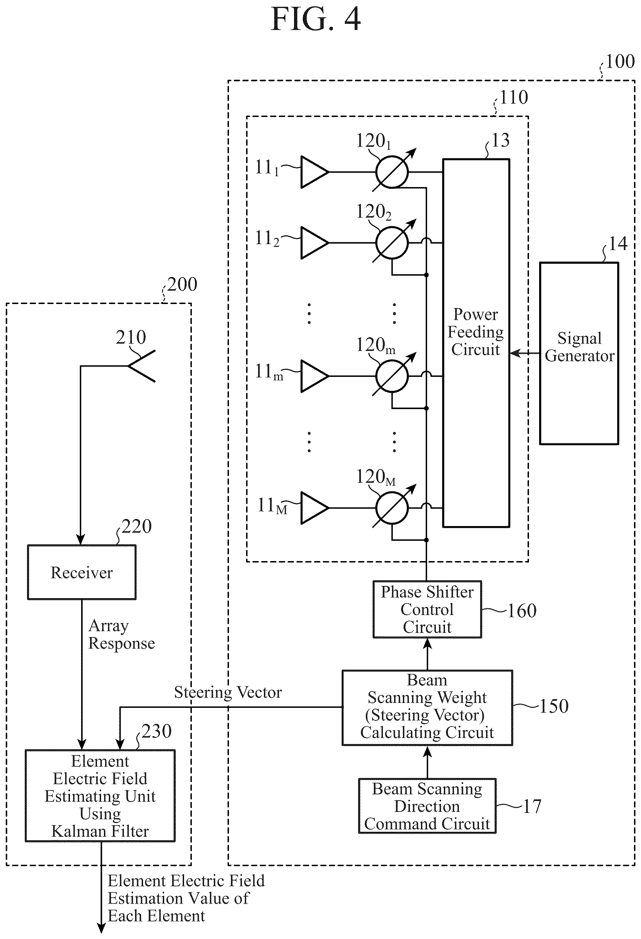

An antenna measurement device according to a fifth embodiment will be described with reference to FIG. 4.

The antenna measurement device according to the fifth embodiment is different in that the antenna measurement device according to the first embodiment is used for the transmission device 100 including the array antenna 10, whereas the antenna measurement device according to the fifth embodiment is used for a transmission device 1 including a phased array antenna 110.

Hereinafter, differences from the antenna measurement device according to the first embodiment will be mainly described.

Note that, in FIG. 4, the same reference numerals as those attached in FIGS. 1 to 2 denote the same or corresponding parts.

As illustrated in FIG. 4, the transmission system includes a transmission device 100 and an antenna measurement device 200.

Note that the transmission system is an assembly of components used when radiating a high-frequency signal in a wireless system.

The transmission device 100 includes the phased array antenna 110, a signal generator 14, a beam scanning weight (steering vector) calculating circuit 150, a phase shifter control circuit 160, and a beam scanning direction command circuit 17.

The phased array antenna 110 includes a plurality of element antennas (hereinafter, referred to as elements) $11_1$ to $11_M$, a plurality of phase shifters $120_1$ to $120_M$, and a power feeding circuit 13.

The plurality of elements $11_1$ to $11_M$ is transmission/reception reversible element antennas that can be used for transmission and reception.

The phased array antenna 110 is a phased array antenna in which a beam scanning weight (steering vector) for each of the plurality of elements $11_1$ to $11_M$ is changed.

The antenna measurement device 200 includes a probe antenna 210, a receiver 220, and an element electric field estimating unit 230.

The receiver 220 is not limited to a dedicated receiver for estimating the element electric field of each of the plurality of elements $11_1$ to $11_M$, and may use a receiver of a reception system used when a high-frequency signal is received in a wireless system.

Each element 11 is connected to the corresponding phase shifter 120.

Each of the plurality of phase shifters 120 is an excitation phase adjusting unit that adjusts an excitation phase given to each of the plurality of corresponding elements 11.

Each phase shifter 120 is controlled on the basis of the beam scanning weight from the phase shifter control circuit 160, and a passing phase indicating the excitation phase is controlled.

Each phase shifter 120 may be configured in any form of an analog circuit or a digital circuit, and a generally known phase shifter is used.

The beam scanning direction command circuit 17 outputs direction indication information that determines the beam scanning direction of the phased array antenna 110.

The beam scanning weight calculating circuit 150 calculates a beam scanning weight given to each of the plurality of elements 11 on the basis of the direction indication information from the beam scanning direction command circuit 17.

The phase shifter control circuit 160 controls each phase shifter 120 on the basis of a phase value indicated by the beam scanning weight calculated by the beam scanning weight calculating circuit 150 to change the excitation phase of each element 11.

That is, the phase shifter control circuit 160 controls the passing phase of each phase shifter 120 to change the beam scanning weight for each element 11.

That is, the high-frequency signal transmitted from the signal generator 14 is power-distributed by the power feeding circuit 13. The power-distributed high-frequency signal is set to an excitation phase on the basis of the beam scanning weight by each phase shifter 120, and is radiated from each element 11 constituting the phased array antenna 110 to the space.

The element electric field estimating unit 230 using the probe antenna 210, the receiver 220, and the Kalman filter in the antenna measurement device 200 basically has the same function as the probe antenna 21, the receiver 22, and the element electric field estimating unit 23 using the Kalman filter in antenna measurement device 20 in the first embodiment.

However, since the fifth embodiment is applied to the phased array antenna 110, a beam scanning weight is applied instead of the excitation weight, and a steering vector $w^T(k)$ represented by the following Expression (17) is used instead of the excitation weight vector $w^T(k)$ represented by the above Expression (1) used in the first embodiment.

$$\mathbf{w}^T(k) = \begin{bmatrix} e^{jk_0\mathbf{r}_1 \cdot \hat{\boldsymbol{\theta}}(k)} & e^{jk_0\mathbf{r}_2 \cdot \hat{\boldsymbol{\theta}}(k)} & \cdots & e^{jk_0\mathbf{r}_M \cdot \hat{\boldsymbol{\theta}}(k)} \end{bmatrix}$$

$$\cdots \quad (1\ 7)$$

In the above Expression (17), $r_m$ is a position vector of the element $11_m$,

$$\hat{\boldsymbol{\theta}}(k)$$

is a beam scanning direction vector, and $k_0$ is a wave number.

As a state equation representing a state space model of the element electric field of each element $11_m$ other than the steering vector $w^T(k)$ corresponding to the excitation weight vector expressed by the above Expression (17) and an observation equation at the time of array response measurement, the same expression as the expression presented in the first embodiment is applied.

The element electric field estimating unit 230 sequentially estimates the element electric field of each of the plurality of elements 11 using the Kalman filter that receives inputs of the array response sequentially output from receiver 220 and the steering vector obtained by the beam scanning weight for each of the plurality of elements 11 calculated by the beam scanning weight calculating circuit 150, and obtains the element electric field estimation value of each element 11.

Next, a procedure for sequentially estimating the element electric field of each of the plurality of elements 11 using the Kalman filter constituting the element electric field estimating unit 230 and obtaining the element electric field estimation value of each element 11 will be briefly described with reference to FIG. 2.

In FIG. 2, there is a difference in that the steering vector $w^T(k)$ corresponding to the excitation weight vector is used instead of the excitation weight vector $w^T(k)$, and a series of procedures of steps ST1 to ST6 is substantially the same as the series of procedures described in the first embodiment.

That is, in step ST1 which is an initialization step, the state vector $x^T(k)$ and the error covariance matrix $P(k)$ are initialized using the initial value $E_m(0)$ of the element electric field of the element $11_m$ (m is 1 to M) measured in advance.

Step ST2, which is a prediction step, obtains the prior state vector x bar (k) and the prior error covariance matrix P bar (k) by the state space model.

In step ST3 which is a filtering step, a posterior state vector x(k) and a posterior error covariance matrix $P(k)$ are obtained on the basis of the array response y(k) and the steering vector $w^T(k)$ which are measurement values detected by the receiver 22.

In step ST4 which is an element electric field estimation step, an element electric field $E_m(k)$ of each element 11 is obtained as the element electric field estimation value of each element 11 on the basis of the state vector x(k).

A series of procedures from step ST2 to step ST6 is repeated from 1 to K of k.

As a result, the element electric field estimating unit 23 can sequentially estimate the element electric field $E_m(k)$ of each element 11 that changes from moment to moment, and can obtain a highly accurate estimation value of the element electric field even if the element electric field of the element 11 changes due to a temperature change, a secular change, or the like of the environment of the transmission device 1.

As described above, the antenna measurement device according to the fifth embodiment is the antenna measurement device 200 that estimates an element electric field of the plurality of element antenna $11_1$ to $11_M$ in the transmission device 100 including the phased array antenna 110 including the element antennas $11_1$ to $11_M$ in which a beam scanning weight with respect to each of the plurality of element antennas is changed, and includes the probe antenna 210 to receive a high-frequency signal radiated by the phased array antenna 110, the receiver 220 to detect a reception signal received by the probe antenna 210 and output an array response that is the detected reception signal in chronological order, and the element electric field estimating unit 230 to estimate the element electric field of each of the plurality of element antennas $11_1$ to $11_M$ using the Kalman filter that receives inputs of the array response output from the receiver 220 in chronological order and a steering vector obtained by the beam scanning weight for each of the plurality of element antennas $11_1$ to $11_M$, and thus the element electric field of each of the plurality of element antennas $11_1$ to $11_M$ can be sequentially estimated.

As a result, even if the element electric field of the element antenna $11_1$ to $11_M$ changes due to a temperature change, a secular change, or the like of the environment of the transmission device 100, a highly accurate estimation value of the element electric field can be obtained.

Furthermore, the element electric field of the element antenna $11_1$ to $11_M$ can be estimated even during the period in which the transmission device 100 is operated.

Sixth Embodiment

An antenna measurement device according to a sixth embodiment is characterized in that a high-frequency signal radiated from each element 11 is made into an orthogonal beam by a beam scanning weight by a phase shifter 120, whereas a high-frequency signal radiated from each of the plurality of elements 11 can be any beam in the antenna measurement device according to the fifth embodiment, and the other points are the same.

The transmission system including the antenna measurement device according to the sixth embodiment is substantially the same as FIG. 4 illustrated in the fifth embodiment, and is characterized in the following points with respect to the antenna measurement device according to the fifth embodiment.

That is, in order to radiate an orthogonal beam group from a phased array antenna 110 including the plurality of elements 11, the beam scanning weight of each element 11 provided by each of the plurality of phase shifters 120 is sequentially switched by the phase shifter control circuit 160 to be a beam scanning weight for forming an orthogonal beam.

On the other hand, on the basis of a reception signal received by a probe antenna 210, a receiver 220 measures an array response corresponding to each orthogonal beam.

The antenna measurement device according to the sixth embodiment has effects similar to those of the antenna measurement device according to the fifth embodiment, and in addition, since the beam scanning weight is used as the beam scanning weight for the plurality of elements 11 to form orthogonal beams, there is no correlation between measurement results of array responses, so that the estimation accuracy of the element electric field of each element 11 is improved.

Seventh Embodiment

An antenna measurement device according to a seventh embodiment is characterized in that an initial value $E_m(0)$ of an element electric field of an element $11_m$ is obtained by a method similar to the method for estimating the element electric field $E_m(k)$ of each element 11, whereas the initial value $E_m(0)$ of the element electric field of the element $11_m$ can be acquired in advance by any acquisition method in the antenna measurement device according to the fifth embodiment, and the other points are the same.

A transmission system including the antenna measurement device according to the seventh embodiment is substantially the same as that of FIG. 4 illustrated in the fifth embodiment, and is characterized in the following points with respect to the antenna measurement device according to the fifth embodiment.

In the antenna measurement device according to the seventh embodiment, the initial value $E_m(0)$ of the element electric field of the element $11_m$ used in step ST1, which is an initialization step for the Kalman filter constituting the element electric field estimating unit 230 described in the fifth embodiment, is obtained as follows.

That is, before the element electric field $E_m(k)$ of each element 11 is estimated, that is, in advance, similarly to the estimation of the element electric field $E_m(k)$ of each element 11, a procedure similar to steps ST2 to ST5 illustrated in FIG. 2 is repeated K times from the index 1 to the index K in chronological order to obtain the initial value $E_m$ of the element electric field of the element $11_m$.

It is assumed that the element electric field of the element $11_m$ does not change in a period of k from 1 to K performed in advance.

Initial values $E_1$ to $E_M$ of the element electric fields of elements $11_1$ to $11_M$ are values of an element electric field obtained by an array response $y(k)$ output from a receiver 22 and steering vectors $w^T(1)$ to $w^T(K)$ by beam scanning weights $w_1(1)$ to $w_M(k)$ for the elements $11_1$ to $11_M$ using the above Expression (16).

The antenna measurement device according to the seventh embodiment has effects similar to those of the antenna measurement device according to the fifth embodiment, and also has an effect that the initial value $E$ of the element electric field of the element 11 can be obtained by a method similar to the method for estimating the element electric field of the element 11 using the antenna measurement device since the initial value is set to a value of the element electric field obtained from the array response output from the receiver 22 and the steering vector obtained by the beam scanning weight for each of the plurality of elements 11.

Note that, in the antenna measurement device according to the seventh embodiment, as in the antenna measurement device according to the sixth embodiment, an orthogonal beam group may be selected as a high-frequency signal radiated from each element 11.

Eighth Embodiment

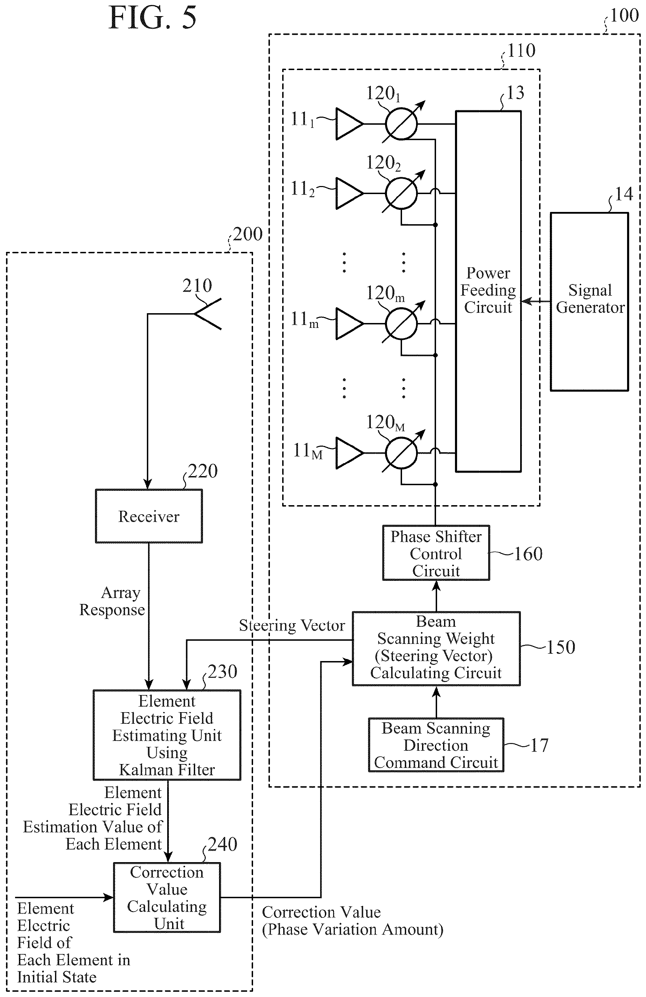

An antenna measurement device according to an eighth embodiment will be described with reference to FIG. 5.

The antenna measurement device according to the eighth embodiment is different in that a beam scanning weight calculated by a beam scanning weight calculating circuit 150 is corrected, that is, calibrated using an element electric field estimation value of each element 11 obtained in the antenna measurement device according to the fifth embodiment, and the other points are the same.

Note that, in FIG. 5, the same reference numerals as those attached in FIGS. 1, 2, and 4 denote the same or corresponding parts.

An antenna measurement device 2 according to the eighth embodiment measures and estimates an element electric field of each of a plurality of elements $11_1$ to $11_M$, calculates a phase variation amount with respect to the element electric field of each element 11 with respect to an initially set beam scanning weight in the beam scanning weight calculating circuit 150 using the estimated element electric field, and outputs a correction value based on the calculated phase variation amount to the beam scanning weight calculating circuit 150.

The beam scanning weight calculating circuit 150 calculates a correction beam scanning weight for the initially set beam scanning weight on the basis of the correction value, calculates a beam scanning weight given to each of the plurality of elements 11 on the basis of the calculated correction beam scanning weight, and outputs a calculation result to a phase shifter control circuit 160.

An antenna measurement device 200 includes a probe antenna 210, a receiver 220, an element electric field estimating unit 230 using a Kalman filter, and a correction value calculating unit 240.

The difference from the antenna measurement device 200 according to the fifth embodiment is that the antenna measurement device 200 according to the eighth embodiment includes the correction value calculating unit 240, and thus the correction value calculating unit 240 will be mainly described below.

The correction value calculating unit 240 compares an element electric field estimation value $E_m(k)$ of each element 11 estimated by the element electric field estimating unit 230 with an element electric field in an initial state of each element 11 with respect to the initially set beam scanning weight in the beam scanning weight calculating circuit 150, and calculates the phase variation amount of the element electric field estimation value with respect to the element electric field in the initial state of each element 11.

The correction value calculating unit 240 outputs the calculated phase variation amount to the beam scanning weight calculating circuit 150 as a correction value (phase variation amount) for returning the element electric field of each element 11 to the element electric field in the initial state.

The element electric field estimation value $E_m(k)$ of each element 11 estimated by the element electric field estimating unit 230 is the same as that obtained by the series of procedures of steps ST1 to ST6 described with reference to FIG. 2, similarly to the fifth embodiment.

The beam scanning weight calculating circuit 150 calculates a correction beam scanning weight for the initially set beam scanning weight on the basis of the correction value from the correction value calculating unit 24, and calculates a beam scanning weight given to each of the plurality of elements 11 on the basis of the calculated correction beam scanning weight.

The beam scanning weight calculated by the beam scanning weight calculating circuit 150 is output to the phase shifter control circuit 160, and the phase shifter control circuit 160 and each phase shifter 120 operate as described in the fifth embodiment.

As a result, the high-frequency signal from the power feeding circuit 13 is set to the excitation phase on the basis of the calibrated beam scanning weight and radiated into the space from each element 11.

Therefore, the element electric field of each element 11 is the same as the element electric field in the initial state.

That is, even if the element electric field of the element 11 changes due to a temperature change, a secular change, or the like of the environment of the transmission device 100, a fluctuation of the element electric field of each element 11 can be sequentially corrected, and the element electric field of each element 11 can be maintained constant.

Note that the beam scanning weight given to each element 11 may be a beam scanning weight for forming an orthogonal beam as described in the sixth embodiment. With this configuration, the estimation accuracy of the element electric field of each element 11 is improved.

In addition, the initial value $E_m$ of the element electric field of each element 11 may be obtained by solving the linear equation of the above Expression (16) in advance using the antenna measurement device 200 as described in the seventh embodiment.

Similarly to the antenna measurement device according to the fifth embodiment, the antenna measurement device according to the eighth embodiment can sequentially estimate the element electric field of each of the element antennas $11_1$ to $11_M$ with high accuracy, and further includes the correction value calculating unit 240 that compares the element electric field of each of the plurality of element antennas $11_1$ to $11_M$ estimated by the element electric field estimating unit 230 using the Kalman filter with the element electric field in the initial state of each of the plurality of element antennas $11_1$ to $11_M$, calculates the phase variation amount of the estimated element electric field with respect to the element electric field in the initial state, and obtains the phase variation amount as the correction value of the beam scanning weight, and thus, when the element electric field of each of the plurality of element antennas $11_1$ to $11_M$ varies, it is possible to sequentially maintain the element electric field constant.

Ninth Embodiment

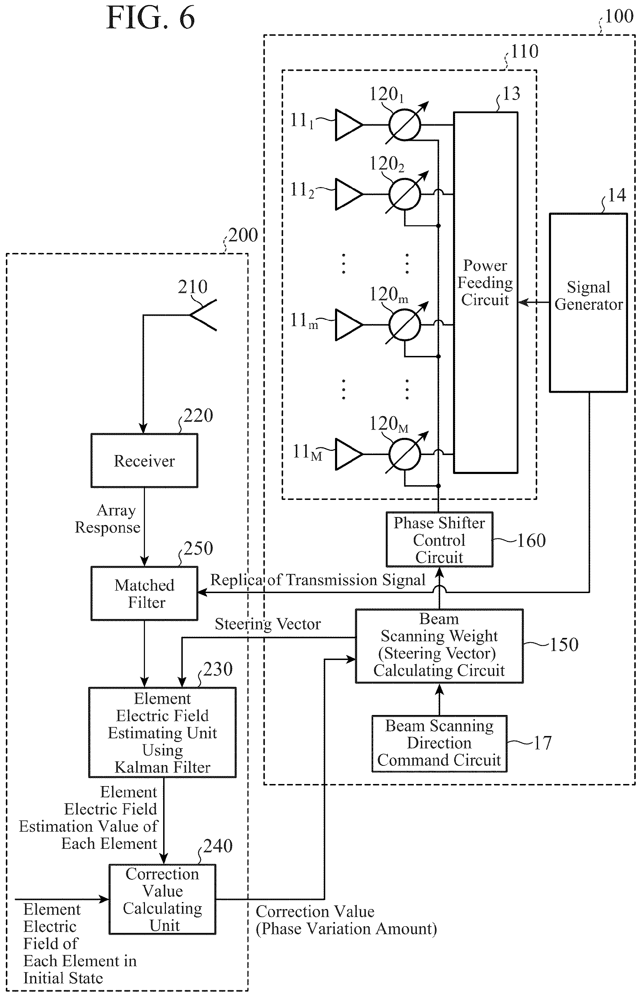

An antenna measurement device according to a ninth embodiment will be described with reference to FIG. 6.

The antenna measurement device according to the ninth embodiment is different from the antenna measurement device according to the eighth embodiment in that the array response as an input of the Kalman filter used for the element electric field estimating unit 230 is an array response obtained by performing correlation processing with a replica of a high-frequency signal to be supplied to a plurality of elements $11_1$ to $11_M$ for the array response output from the receiver 220, and the other points are the same.

Note that, in FIG. 6, the same reference signs as those in FIG. 5 denote the same or corresponding parts.

An antenna measurement device 200 includes a probe antenna 210, a receiver 220, an element electric field estimating unit 230 using a Kalman filter, a correction value calculating unit 240, and a matched filter 250.

Since the difference from the antenna measurement device 200 according to the ninth embodiment is that the antenna measurement device 200 according to the fifth embodiment includes the matched filter 250, the matched filter 250 will be mainly described below.

The matched filter 250 outputs the array response y(k) output from the receiver 220.

A replica of the high-frequency signal to be supplied to the plurality of elements $11_1$ to $11_M$, that is, a replica of the high-frequency signal from the signal generator 14 is input, and correlation processing between the array response y(k) and the replica of the high-frequency signal is performed.

The array response obtained by the matched filter 250 performing the correlation processing is used as an input of the Kalman filter constituting the element electric field estimating unit 230.

As a result, it is possible to obtain a signal processing gain that maximizes the signal-to-noise power (S/N) ratio of the array response y(k) output from a receiver 220 and used as an input of the Kalman filter, and thus the estimation accuracy of the element electric field of each element 11 is improved.

The antenna measurement device according to the ninth embodiment has effects similar to those of the antenna measurement device according to the eighth embodiment, and in addition, since the array response used as an input of the Kalman filter constituting the element electric field estimating unit 23 is the array response obtained by performing correlation processing with the replica of the high-frequency signal to be supplied to the plurality of elements $11_1$ to $11_M$ with respect to the array response output from the receiver 220, the S/N ratio of the array response is improved, and furthermore, the estimation accuracy of the element electric field of each element 11 is improved, and eventually, the calibration accuracy for the element electric field of each element 11 is improved.

The matched filter 250 in the antenna measurement device according to the ninth embodiment may be applied to each of the antenna measurement devices according to the first to seventh embodiments.

That is, in the antenna measurement device according to each of the embodiments, the array response as the input of the Kalman filter constituting the element electric field estimating unit 23 is the array response obtained by performing the correlation processing on the array response output from the receiver 220 by the matched filter 250 with the replica of the high-frequency signal from the signal generator 14, whereby the estimation accuracy of the element electric field of each element 11 in each of the embodiments is further improved.

Tenth Embodiment

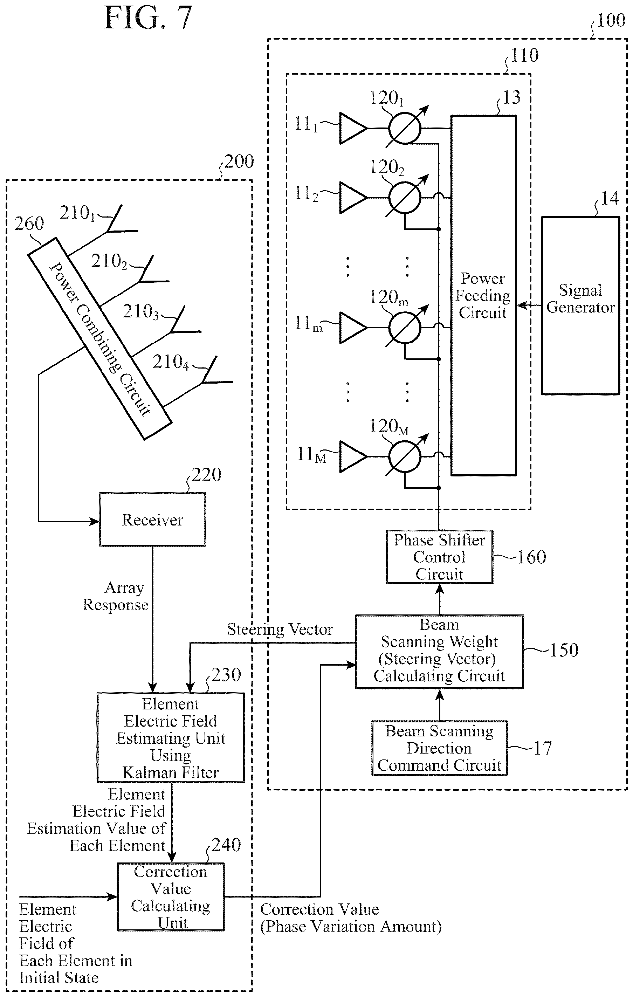

An antenna measurement device according to a tenth embodiment will be described with reference to FIG. 7.

The antenna measurement device according to the tenth embodiment is different from the antenna measurement device according to the eighth embodiment in that a plurality of probe antenna elements and a power combining circuit are included as probe antennas, and the other points are the same.

Note that, in FIG. 7, the same reference numerals as those attached in FIGS. 1, 2, 4, and 5 denote the same or corresponding parts.

A probe antenna 210 in an antenna measurement device 200 according to the tenth embodiment includes a power combining circuit 260 that performs power combining of reception signals of the plurality of probe antenna elements $210_1$ to $210_4$ and the plurality of probe antenna elements $210_1$ to $210_4$.

The plurality of probe antenna elements $210_1$ to $210_4$ and the power combining circuit 260 constitute an array antenna.

By using the array antenna as the probe antenna, the S/N ratio of a reception signal input to a receiver 220 is improved, and as a result, the estimation accuracy of the element electric field of each element 11 is improved.

Note that, although four probe antenna elements $210_1$ to $210_4$ constituting the array antenna are illustrated in FIG. 7, the number of probe antenna elements is not limited to four, and it is only necessary to use a plurality of probe antenna elements.

The antenna measurement device according to the tenth embodiment has effects similar to those of the antenna measurement device according to the eighth embodiment. In addition, since the probe antenna 210 is an array antenna, the S/N ratio of the reception signal input to the receiver 220 is improved, and the estimation accuracy of the element electric field of each element 11 is improved.

A probe antenna having an array antenna configuration in the antenna measurement device according to the tenth embodiment may be applied to each of the antenna measurement devices according to the first to seventh embodiments and the ninth embodiment.

That is, in the antenna measurement device according to each of the embodiments, the probe antenna 210 includes the plurality of probe antenna elements $210_1$ to $210_4$ and the power combining circuit 260 that performs power combining of the reception signals of the plurality of probe antenna elements $210_1$ to $210_4$, whereby the estimation accuracy of the element electric field of each element 11 in each embodiment is further improved.

Eleventh Embodiment

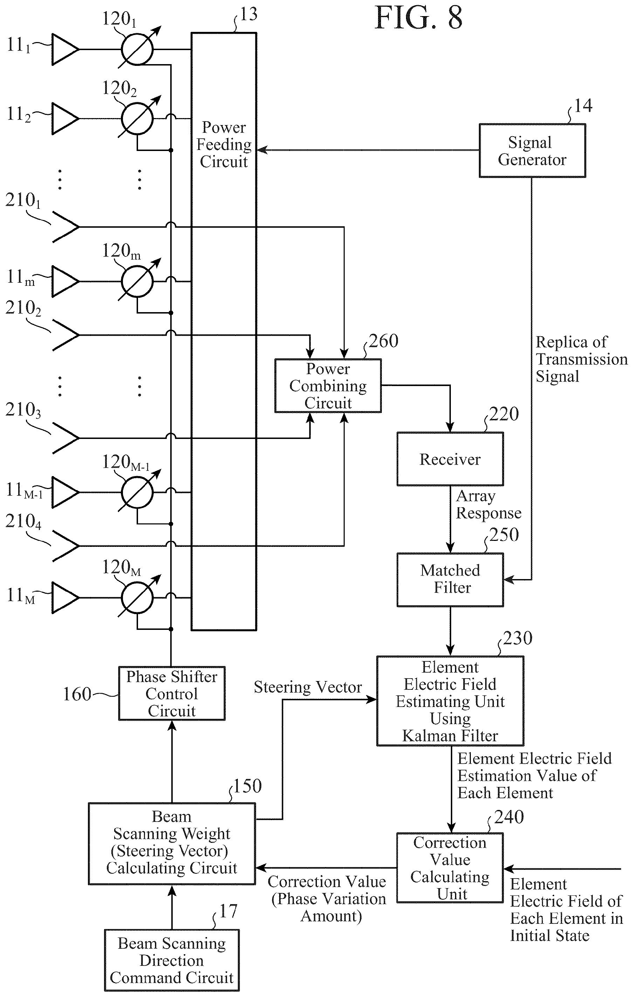

An antenna measurement device according to an eleventh embodiment will be described with reference to FIG. 8.

The antenna measurement device according to the eleventh embodiment is different from the antenna measurement device according to the tenth embodiment in that a plurality of probe antenna elements $210_1$ to $210_4$ constituting a probe antenna has openings arranged on the same plane as openings of a plurality of elements $11_1$ to $11_M$ constituting a phased array antenna 110, and that an array response as an input of the Kalman filter used for an element electric field estimating unit 23 is an array response obtained by performing correlation processing with a replica of a high-frequency signal to be supplied to the plurality of elements $11_1$ to $11_M$ with respect to an array response output from a receiver 220.

Note that, in FIG. 8, the same reference numerals as those attached in FIGS. 1 to 7 denote the same or corresponding parts.

An antenna measurement device 200 includes a probe antenna 210, a receiver 220, an element electric field estimating unit 230 using a Kalman filter, a correction value calculating unit 240, and a matched filter 250.

Since it is different from the antenna measurement device 200 according to the tenth embodiment in the arrangement of the plurality of elements $11_1$ to $11_M$ and in that the matched filter 250 is included in the antenna measurement device 200 according to the eleventh embodiment, the arrangement of the plurality of elements $11_1$ to $11_M$ and the matched filter 250 will be mainly described below.

The plurality of probe antenna elements $210_1$ to $210_4$ is arranged with respect to the plurality of elements $11_1$ to $11_M$ in such a manner that the openings of the plurality of probe antenna elements $210_1$ to $210_4$ constituting the probe antenna are arranged on the same plane as the openings of the plurality of elements $11_1$ to $11_M$ constituting the phased array antenna 110.

In this manner, by arranging the plurality of probe antenna elements $210_1$ to $210_4$ on the same plane as the plurality of elements $11_1$ to $11_M$, the entire transmission system can be downsized.

Further, similarly to the antenna measurement device according to the ninth embodiment, the matched filter 250 receives an array response y(k) output from the receiver 220 and the replica of the high-frequency signal from the signal generator 14 as inputs, and performs correlation processing between the array response y(k) and the replica of the high-frequency signal.

Therefore, it is possible to obtain a signal processing gain that maximizes the S/N ratio of the array response y(k) output from the receiver 220 and used as an input of the Kalman filter, and thus the estimation accuracy of the element electric field of each element 11 is improved.

The antenna measurement device according to the eleventh embodiment has effects similar to those of the antenna measurement device according to the tenth embodiment, and in addition, since the openings of the probe antenna elements 210 are disposed on the same plane as the openings of the elements 11, downsizing of the entire transmission system can be achieved, and since the array response used as an input of the Kalman filter constituting the element electric field estimating unit 23 is the array response obtained by performing correlation processing with the replica of the high-frequency signal to be supplied to the plurality of elements $11_1$ to $11_M$ with respect to the array response output from the receiver 220, the S/N ratio of the array response is improved, and furthermore, the estimation accuracy of the element electric field of each element 11 is improved, and eventually, the calibration accuracy for the element electric field of each element 11 is improved.

The idea of arranging the probe antenna with respect to the element 11 in such a manner that the opening of the probe antenna in the antenna measurement device according to the eleventh embodiment is disposed on the same plane as the openings of the plurality of elements 11 may be applied to each of the antenna measurement devices according to the first to ninth embodiments.

That is, in the antenna measurement devices according to each of the embodiments, by arranging the openings of the probe antennas on the same plane as the openings of the plurality of elements 11, the entire transmission system can be downsized.

Twelfth Embodiment

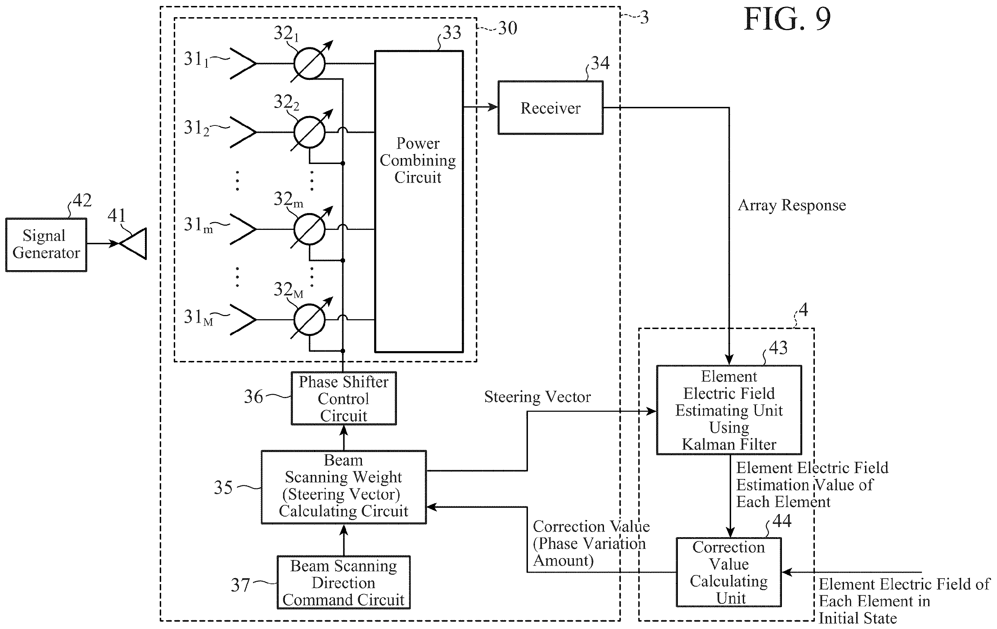

An antenna measurement device according to a twelfth embodiment will be described with reference to FIG. 9.

FIG. 9 is a configuration diagram illustrating a schematic configuration of a reception system including the antenna measurement device according to the twelfth embodiment.

As illustrated in FIG. 9, the reception system includes a reception device 3 and an antenna measurement device 4.

Note that the reception system is an assembly of components used when a high-frequency signal is received in a wireless system.

The reception device 3 includes a phased array antenna 30, a receiver 34, a beam scanning weight (steering vector) calculating circuit 35, a phase shifter control circuit 36, and a beam scanning direction command circuit 37.

The phased array antenna 30 includes a plurality of element antennas (hereinafter, referred to as elements) $31_1$ to $31_M$, a plurality of phase shifters $32_1$ to $32_M$, and a power combining circuit 33.

The plurality of elements $31_1$ to $31_M$ is transmission/reception reversible element antennas that can be used for reception and transmission.

The phased array antenna 30 is a phased array antenna in which a beam scanning weight (steering vector) for each of the plurality of elements $31_1$ to $31_M$ is changed.

The antenna measurement device 4 includes an element electric field estimating unit 43 using a Kalman filter and a correction value calculating unit 44.

The antenna measurement device according to the twelfth embodiment is an example applied to a reception system in a wireless system, and is different from the antenna measurement device according to the eighth embodiment applied to a transmission system in a wireless system in whether an element electric field of element antennas $11_1$ to $11_M$ is estimated by receiving a high-frequency signal radiated from the plurality of element antennas $11_1$ to $11_M$ or an element electric field of a plurality of element antennas $31_1$ to $31_M$ is estimated by receiving a high-frequency signal radiated from a probe antenna 41, and the antenna measurement device according to the twelfth embodiment is substantially the same as the antenna measurement device according to the eighth embodiment in operation and function.

Note that, although the probe antenna 41 and the signal generator 42 are illustrated in FIG. 9 for convenience, the probe antenna 41 and the signal generator 42 illustrated in FIG. 9 may be provided exclusively for estimating the element electric field of each of the plurality of elements $31_1$ to $31_M$, but are an antenna and a signal generator used when radiating a high-frequency signal in another wireless system. In order to eliminate the complexity of the description, an antenna in another wireless system will be described as a probe antenna 41 below.

In the antenna measurement device according to the twelfth embodiment, the element electric field estimated for the plurality of element antennas $31_1$ to $31_M$ means the high-frequency signal received by each of the plurality of element antennas $31_1$ to $31_M$, and the amplitude and the phase of the received high-frequency signal are represented by complex numbers.

The reception device 3 is the same as a generally known reception device, and thus the reception device 3 will be briefly described below. Each element 31 receives a high-frequency signal, and a reception signal received by each element 31 is given a phase change corresponding to the beam scanning weight by the corresponding phase shifter 32, combined by the power combining circuit 33, and input to the receiver 34 as a high-frequency reception signal.

The beam scanning direction command circuit 37 outputs direction indication information that determines the beam scanning direction of the phased array antenna 30.

The beam scanning weight calculating circuit 35 calculates a beam scanning weight given to each of the plurality of elements 31 on the basis of the direction indication information from the beam scanning direction command circuit 37.

The phase shifter control circuit 36 controls a passing phase of each phase shifter 32 to change the beam scanning weight for each element 31.

Next, estimation of the element electric field of each element 31 will be mainly described.

Now, a description will be given assuming that a series of procedures for sequential estimation is repeated K times in chronological order from the index 1 to the index K.

During the processing period from 1 to K of the index k for estimating the element electric field, the reception system may be in operation, and when the reception system is in operation, a wireless signal in operation is used as the reception signal for estimating the element electric field at the same time.

The high-frequency signal radiated from the probe antenna 41 is received by each element 31, and the reception signal received by each element 31 is given a phase change corresponding to the beam scanning weight by the corresponding phase shifter 32, combined by the power combining circuit 33, and input to the receiver 34.

The element electric field estimating unit 43 sequentially estimates the element electric field of each of the plurality of elements 31 using the Kalman filter that receives inputs of the array response sequentially output from receiver 34 and the steering vector obtained by the beam scanning weight for each of the plurality of elements 31 calculated by beam scanning weight calculating circuit 35, and obtains an element electric field estimation value of each element 31.

The correction value calculating unit 44 compares the element electric field estimation value $E_m(k)$ of each element 31 estimated by the element electric field estimating unit 43 with the element electric field in the initial state of each element 31 with respect to the initially set beam scanning weight in the beam scanning weight calculating circuit 35, and calculates the phase variation amount of the element electric field estimation value with respect to the element electric field in the initial state of each element 31.

The correction value calculating unit 44 outputs the calculated phase variation amount to the beam scanning weight calculating circuit 35 as a correction value (phase variation amount) for returning the element electric field of each element 31 to the element electric field in the initial state.

The electric field estimation value by the element electric field estimation value $E_m(k)$ of each element 31 estimated by the element electric field estimating unit 43 is obtained by a series of procedures from step ST1 to step ST6 described with reference to FIG. 2, which is performed as in the eighth embodiment.

The beam scanning weight calculating circuit 35 calculates a correction beam scanning weight for the initially set beam scanning weight on the basis of the correction value from the correction value calculating unit 44, and calculates a beam scanning weight given to each of the plurality of elements 31 on the basis of the calculated correction beam scanning weight.

Also in the antenna measurement device 4 according to the twelfth embodiment, the element electric field estimating unit 23 can sequentially estimate the element electric field $E_m(k)$ of each element 31 that changes from moment to moment by repeating a procedure similar to the series of procedures illustrated in steps ST2 to ST6 from 1 to K of k, and can obtain a highly accurate estimation value of the element electric field even if the element electric field of the element 31 changes due to a temperature change, a secular change, or the like of the environment of the reception device 3.

An antenna measurement device according to the twelfth embodiment is an antenna measurement device that estimates an element electric field of the element antenna $31_1$ to $31_M$ in a reception device including the phased array antenna 30 having a plurality of element antennas $31_1$ to $31_M$ and having a beam scanning weight changed for each of the plurality of element antennas $31_1$ to $31_M$, and since the antenna measurement device includes: the element electric field estimating unit 43 that detects a reception signal received by the plurality of element antennas $31_1$ to $31_M$ and estimates an element electric field of each of the plurality of element antennas $31_1$ to $31_M$ using a Kalman filter that receives inputs of an array response output in chronological order from the receiver 34 that outputs an array response that is the detected reception signal in chronological order and a steering vector obtained by the beam scanning weight for each of the plurality of element antennas $31_1$ to $31_M$; and the correction value calculating unit 44 that compares an element electric field of each of the plurality of element antennas $31_1$ to $31_M$ estimated by the element electric field estimating unit 43 and an element electric field in an initial state of each of the plurality of element antennas $31_1$ to $31_M$, calculates the phase variation amount of the estimated element electric field with respect to the element electric field in the initial state and obtains the phase variation amount as the correction value of the beam scanning weight, it is possible to sequentially estimate the element electric field of each of the plurality of element antennas $31_1$ to $31_M$ and to sequentially maintain the element electric field constant when the element electric field of each of the plurality of element antennas $31_1$ to $31_M$ varies.

Note that the initial value $E_m$ of the element electric field of each element 31 may be obtained by solving the linear equation of the above Expression (16) in advance using the antenna measurement device 4 as described in the seventh embodiment.

In addition, the idea of applying the antenna measurement device according to the twelfth embodiment to a reception system may be applied to a reception system for a transmission system to which the antenna measurement device according to the first embodiment is applied, that is, a reception device including an array antenna including a plurality of element antennas, an excitation weight adjusting circuit, and a power combining circuit, a receiver, an excitation weight calculating circuit, and an excitation weight control circuit.

Furthermore, the matched filter 250 described in the antenna measurement device according to the ninth embodiment may be applied to the antenna measurement device according to the twelfth embodiment.

Note that free combinations of the individual embodiments, modifications of any components of the individual embodiments, or omissions of any components in the individual embodiments are possible.

INDUSTRIAL APPLICABILITY

The antenna measurement device according to the present disclosure is suitable for an antenna measurement device incorporated in a wireless system such as wireless communication or radar.

REFERENCE SIGNS LIST

1, 100: transmission device, 10: array antenna, $11_1$ to $11_M$: element, $12_1$ to $12_M$: excitation weight adjusting circuit, 13: power feeding circuit, 14: signal generator, 15: excitation weight calculating circuit, 16: excitation weight control circuit, 2, 200: antenna measurement device, 21, 210: probe antenna, 22, 220: receiver, 23, 230: element electric field estimating unit, 24, 240: correction value calculating unit, 110: phased array antenna, $120_1$ to $120_M$: phase shifter, 150: beam scanning weight calculating circuit, 160: phase shifter control circuit, 17: beam scanning direction command circuit, 250: matched filter, 3: reception device, 30: phased array antenna, $31_1$ to $31_M$: element, $32_1$ to $12_M$: phase shifter, 33: power combining circuit, 34: receiver, 35: beam scanning weight calculating circuit, 36: phase shifter control circuit, 37: beam scanning direction command circuit, 4: antenna measurement device, 41: probe antenna, 42: signal generator, 43: element electric field estimating unit

**Claims**

1. An antenna measurement device that estimates an element electric field of a plurality of element antennas in a transmission device including an array antenna including the element antennas in which an excitation weight indicating an amplitude and a phase with respect to each of the plurality of element antennas is changed, the antenna measurement device comprising:

   a probe antenna to receive a high-frequency signal radiated by the array antenna;
   a receiver to detect a reception signal received by the probe antenna and output an array response that is the detected reception signal in chronological order; and
   an element electric field estimating unit to estimate an element electric field of each of the plurality of element antennas using a Kalman filter that receives inputs of the array response output from the receiver in chronological order and an excitation weight vector obtained by the excitation weight for each of the plurality of element antennas.

2. An antenna measurement device that estimates an element electric field of a plurality of element antennas in a transmission device including a phased array antenna including the element antennas in which a beam scanning weight with respect to each of the plurality of element antennas is changed, the antenna measurement device comprising:

   a probe antenna to receive a high-frequency signal radiated by the phased array antenna;
   a receiver to detect a reception signal received by the probe antenna and output an array response that is the detected reception signal in chronological order; and
   an element electric field estimating unit to estimate the element electric field of each of the plurality of element antennas using a Kalman filter that receives inputs of the array response output from the receiver in chronological order and a steering vector obtained by the beam scanning weight for each of the plurality of element antennas.

3. The antenna measurement device according to claim 1, further comprising a correction value calculating unit to compare the element electric field of each of the plurality of element antennas estimated by the element electric field estimating unit with an element electric field in an initial state of each of the plurality of element antennas, calculate a variation amount of the estimated element electric field with respect to the element electric field in the initial state, and obtain the variation amount as a correction value of the excitation weight.

4.   The antenna measurement device according to claim 2, further comprising a correction value calculating unit to compare the element electric field of each of the plurality of element antennas estimated by the element electric field estimating unit with an element electric field in an initial state of each of the plurality of element antennas, calculate a phase variation amount of the estimated element electric field with respect to the element electric field in the initial state, and obtain the phase variation amount as a correction value of the beam scanning weight.

5.   The antenna measurement device according to claim 1 or 3, wherein the excitation weight is an excitation weight for the plurality of element antennas to form an orthogonal beam.

6.   The antenna measurement device according to claim 2 or 4, wherein the beam scanning weight is a beam scanning weight for the plurality of element antennas to form an orthogonal beam.

7.   The antenna measurement device according to claim 1 or 3, wherein the initial value of the element electric field of each of the plurality of element antennas with respect to the Kalman filter constituting the element electric field estimating unit is set to a value of an element electric field obtained by an array response output from the receiver and an excitation weight vector obtained by an excitation weight for each of the plurality of element antennas in a period in which the element electric field of each of the plurality of element antennas does not change.

8.   The antenna measurement device according to claim 2 or 4, wherein the initial value of the element electric field of each of the plurality of element antennas with respect to the Kalman filter constituting the element electric field estimating unit is set to a value of an element electric field obtained by an array response output from the receiver and a steering vector obtained by a beam scanning weight for each of the plurality of element antennas in a period in which the element electric field of each of the plurality of element antennas does not change.

9.   The antenna measurement device according to any one of claims 1 to 4, wherein the array response used as an input of the Kalman filter is an array response obtained by performing correlation processing on the array response output from the receiver with a replica of a high-frequency signal to be supplied to the element antenna.

10.   The antenna measurement device according to any one of claims 1 to 4, wherein the probe antenna includes a plurality of probe antenna elements and a power combining circuit that performs power combining of reception signals from the plurality of probe antenna elements.

11.   The antenna measurement device according to any one of claims 1 to 4, wherein the probe antenna has an opening disposed on a same plane as an opening of each of the plurality of element antennas.

12.   An antenna measurement device that estimates an element electric field of a plurality of element antennas in a reception device including an array antenna including the element antennas in which an excitation weight indicating an amplitude and a phase with respect to each of the plurality of element antennas is changed, the antenna measurement device comprising:
an element electric field estimating unit to detect a reception signal received by the array antenna and estimate an element electric field of each of the plurality of element antennas using a Kalman filter that receives inputs of an array response output in chronological order from a receiver that outputs an array response that is the detected reception signal in chronological order and an excitation weight vector obtained by the excitation weight for each of the plurality of element antennas.

13.   An antenna measurement device that estimates an element electric field of a plurality of element antennas in a reception device including a phased array antenna including the element antennas in which a beam scanning weight with respect to each of the plurality of element antennas is changed, the antenna measurement device comprising:
an element electric field estimating unit to detect a reception signal received by the phased array antenna and estimate an element electric field of each of the plurality of element antennas using a Kalman filter that receives inputs of an array response output in chronological order from a receiver that outputs an array response that is the detected reception signal in chronological order and a steering vector obtained by the beam scanning weight for each of the plurality of element antennas.

14. The antenna measurement device according to claim 12, further comprising a correction value calculating unit to compare the element electric field of each of the plurality of element antennas estimated by the element electric field estimating unit with an element electric field in an initial state of each of the plurality of element antennas, calculate a variation amount of the estimated element electric field with respect to the element electric field in the initial state, and obtain the variation amount as a correction value of the excitation weight.

15. The antenna measurement device according to claim 13, further comprising a correction value calculating unit to compare the element electric field of each of the plurality of element antennas estimated by the element electric field estimating unit with an element electric field in an initial state of each of the plurality of element antennas, calculate a phase variation amount of the estimated element electric field with respect to the element electric field in the initial state, and obtain the phase variation amount as a correction value of the beam scanning weight.

# FIG. 1

# FIG. 2

```
          ( START )
              │
              ▼
```

ST1
- Initialization Step

Initialization of
State Vector and
Error Covariance Matrix

← Initial Value (Known) of
Element Electric Field of
Each Element
$E_m(0)$   $m = 1, 2....M$

$k = 1, 2....K$

ST2
- Prediction Step

Prediction of
Prior State Vector by
State Space Model and
Prior Error Covariance Matrix

← State Space Model (Known)
$\mathbf{A}$    $\mathbf{b}$    $\sigma_V$

ST3
- Filtering Step

Estimate Posterior
State Vector and
Posterior Error
Covariance Matrix on
Basis of Measurement Value

← Array Response (Input)
$y(k)$

← Excitation Weight Vector
(Input)
$w^T(k)$

← Observation Noise Power
(Known)
$\sigma_V$

$k = k + 1$  ─ ST6

Output Element Electric
Field of Each Element
$E_m(k)$   $m = 1, 2....M$  ─ ST4

ST5
$k < K$

YES

NO

( END )

FIG. 3

# FIG. 4

## FIG. 5

FIG. 6

FIG. 7

## FIG. 8

$11_1$ ▷— $120_1$ ⊘

$11_2$ ▷— $120_2$ ⊘

$210_1$ ≻

$11_m$ ▷— $120_m$ ⊘

$210_2$ ≻

$210_3$ ≻

$11_{M-1}$ ▷— $120_{M-1}$ ⊘

$210_4$ ≻

$11_M$ ▷— $120_M$ ⊘

13 Power Feeding Circuit

14 Signal Generator

Replica of Transmission Signal

260 Power Combining Circuit

220 Receiver

Array Response

250 Matched Filter

160 Phase Shifter Control Circuit

Steering Vector

230 Element Electric Field Estimating Unit Using Kalman Filter

Element Electric Field Estimation Value of Each Element

150 Beam Scanning Weight (Steering Vector) Calculating Circuit

240 Correction Value Calculating Unit

Correction Value (Phase Variation Amount)

Element Electric Field of Each Element in Initial State

17 Beam Scanning Direction Command Circuit

EP 4 734 388 A1

FIG. 9

Signal Generator 42

41

$31_1$ $32_1$
$31_2$ $32_2$
$31_m$ $32_m$
$31_M$ $32_M$

Power Combining Circuit 33

30

Receiver 34

3

Array Response

4

Element Electric Field Estimating Unit Using Kalman Filter 43

Element Electric Field Estimation Value of Each Element

Correction Value Calculating Unit 44

Element Electric Field of Each Element in Initial State

Phase Shifter Control Circuit 36

Steering Vector

Beam Scanning Weight (Steering Vector) Calculating Circuit 35

Correction Value (Phase Variation Amount)

Beam Scanning Direction Command Circuit 37

## INTERNATIONAL SEARCH REPORT

| | International application No. |
|---|---|
| | **PCT/JP2023/029013** |

| **A.** | **CLASSIFICATION OF SUBJECT MATTER** |
|---|---|

*H04B 7/06*(2006.01)i; *H04B 7/08*(2006.01)i
FI:  H04B7/06 982; H04B7/08 982

According to International Patent Classification (IPC) or to both national classification and IPC

| **B.** | **FIELDS SEARCHED** |
|---|---|

Minimum documentation searched (classification system followed by classification symbols)

H04B7/06; H04B7/08

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

IEEE Xplore

| **C.** | **DOCUMENTS CONSIDERED TO BE RELEVANT** |
|---|---|

| Category* | Citation of document, with indication, where appropriate, of the relevant passages | Relevant to claim No. |
|---|---|---|
| A | 高橋 徹 他, アクティブフェーズドアレーアンテナの自己診断システムの測定精度改善に関する一検討, ２００３年電子情報通信学会通信ソサイエティ大会講演論文集１ (Proceedings of the 2003 Society Conference of IEICE, vol. 1) , 10 September 2003, B-1-79, p.79, non-official translation (TAKAHASHI, Tooru, A study on improving measurement accuracy of a self-diagnosis system for active phased array antennas) <br> sections 1, 2, fig. 1-2 | 1-15 |
| A | JP 2009-21661 A (SUMITOMO ELECTRIC INDUSTRIES, LTD.) 29 January 2009 (2009-01-29) <br> paragraphs [0029]-[0062], fig. 1-5 | 1-15 |
| A | AKKAD, Ghattas et al., Low Complexity Robust Adaptive Beamformer Based On Parallel RLMS and Kalman RLMS, 2019 27th European Signal Processing Conference (EUSIPCO), September 2019, DOI: 10.23919/EUSIPCO.2019.8902999 <br> section II | 1-15 |

| ☐ Further documents are listed in the continuation of Box C. | ☑ See patent family annex. |
|---|---|

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **16 October 2023** | **24 October 2023** |

| Name and mailing address of the ISA/JP | Authorized officer |
|---|---|
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (January 2015)

## INTERNATIONAL SEARCH REPORT
### Information on patent family members

International application No.

**PCT/JP2023/029013**

| Patent document cited in search report | Publication date (day/month/year) | Patent family member(s) | Publication date (day/month/year) |
|---|---|---|---|
| JP 2009-21661 A | 29 January 2009 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- A Fast Accurate Scheme for Calibration of Active Phased-Array Antennas. **G.A. HAMPSON** ; **A.B. SMOLDER**. 1999 IEEE AP-S Int. Symp. Digest. 1999, 1040-1043

- Over-the-Air Array Calibration of mmWave Phased Array in Beam-Steering Mode Based on Measured Complex Signals. **Z. WANG** ; **F. ZHANG** ; **H. GAO** ; **O. FRANEK** ; **G. F. PEDERSEN** ; **W. FAN**. IEEE Trans AP. 2021, vol. 69, 7876-7888